# EUROPEAN PATENT SPECIFICATION

(11) **EP 0 334 657 B1**
(45) Date of publication and mention of the grant of the patent: **30.11.1994**
(21) Application number: 89302924.9
(22) Date of filing: 23.03.1989
(51) Int. Cl.: C25D 3/38, C25D 5/16, H05K 3/38

(54) **Method of surface treatment of copper foil or copper clad laminate for internal layer**
Verfahren für die Oberflächenbehandlung einer Kupferfolie oder eines kupferbeschichteten Laminates zur Verwendung als Innenschicht
Méthode de traitement superficiel d'une lame de cuivre ou d'un laminé revêtu de cuivre pour couche interne

(30) Priority: 25.03.1988 JP 72706/88
(43) Date of publication of application: 27.09.1989
(73) Proprietor: FUKUDA METAL FOIL & POWDER INDUSTRIAL CO. LTD., Kyoto (JP)
(72) Inventor: Toshiyuki, Kajihara, Yanashina-ku Kyoto (JP); Katsuhito, Fukuda, Yamashina-ku Kyoto (JP); Masato, Takami, Yamashina-ku Kyoto (JP)
(74) Representative: Arthur, Bryan Edward

(56) References cited:
- CHEMICAL ABSTRACTS, vol. 69, no. 16, 14th October 1968, page 5982, abstract no. 64051z, Columbus, Ohio, US; N.N. BALASHOVA et al.: "Diethylenetriaminepentaacetic acid electrolyte for copper plating",& ZASHCH. METAL. 1968, 4(2), 213-15
- CHEMICAL ABSTRACTS, vol. 99, no. 6, 8th August 1983, page 449, abstract no. 45439k, Columbus, Ohio, US; & JP-A-58 09 996

## Description

The present invention relates to surface treatment of copper, and particularly to a method for treating the copper surface of a copper clad laminate used as internal layer circuit in a multilayer printed circuit board, and to a method for treating the surface of copper foil for printed circuit boards.

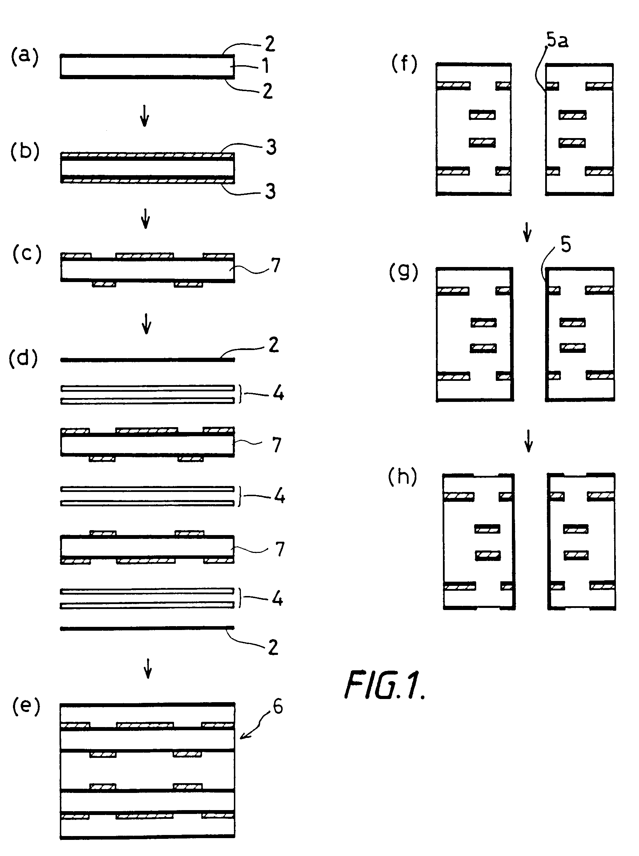

Fig. 1 shows a process for producing a multi layer printed circuit board. First, as shown in Fig. 1(a), a copper clad laminate is prepared by pressing copper foil (2) onto both sides of a glass-fiber reinforced resin sheet (for example, of epoxy-resin) (1). Next, as shown in Fig. (b), a rough surface (3) is produced by a surface treatment, that is subject matter of the invention, on the copper surface of the laminate, as shown in Fig. 1(b). Then, as shown in Fig. 1(c), a conductor pattern for the internal layer is formed on the copper. The board 7 with its conductor pattern is then further laminated to form a multilayer board as shown in Fig. 1(d).

Subsequently, as shown in Fig. 1(f), through holes 5a are bored and through hole plating is carried out as shown in Fig. 1(g). Then, as shown in Fig. 1(h), the surface pattern is formed by etching.

It has been proposed to improve the bondability of the copper surfaces of the internal layers with sheet resin prepregs by forming a rough surface composed of copper oxide by immersing the surface into a high temperature bath of alkaline chlorite near its boiling point. This is called black-oxide (brown-oxide) treatment. For example, as shown in Japanese Patent Publication No. 61-13400, after making a copper surface rough chemically by an aqueous solution containing cupric chloride and hydrochloric acid in advance as pretreatment, the surface is immersed into an aqueous solution containing ammonium acetate, cupric acetate, ammonium chloride and aqueous ammonia or an aqueous solution containing trisodium phosphate, sodium hydroxide and sodium chlorite, whereby an oxide film is chemically formed.

However, such a copper oxide film is poor in acid resistance and particularly very poor in hydrochloric acid resistance. High density multilayer boards for surface mounting with a large number of through holes of small size or landless through holes have come into wide use recently. When such a board is immersed into an aqueous solution containing hydrochloric acid for etching back after drilling through holes as multilayer board, or for the activation pretreatment for electroless copper plating, the copper oxide film layer which acts as a bonding surface between the resin and copper in the through hole is dissolved, accompanied by corrosion of the copper, that is the so-called haloing pink-ring phenomenon and problems such as poor bondability or delamination occur.

To improve such defects, for example, a method wherein the chemical resistance of copper surface is improved by electrolytic reduction of a copper oxide film prepared in advance is proposed in Japanese Patent Publication No. 60-143689 and a method wherein a copper oxide film is reduced by use of an imidazole-type solution is proposed in Japanese Patent Publication No. 60-133794.

However, in any method, the above reducing treatment was required to be conducted after the usual black-oxide treatment at a high working temperature near the boiling point of the solution and accordingly, these methods had the disadvantage that many processes were necessary, leading to complexity, a strict control of reduction was required and the finished appearance and rough surface were not uniform.

The primary object of the invention is to provide a method of making a laminate, including the surface treatment of a copper layer giving high acid resistance and sufficient peeling strength without black-oxide treatment as mentioned above. Further objects of the invention include a method of surface treatment involving fewer steps and shorter treatment time and not requiring high temperatures.

Chemical Abstracts vol. 69 (1968) No. 64051 describes an investigation into the effect of adding diethylenetriamine penta-acetic acid to a copper plating bath. It reports that a finely crystalline copper deposit was obtained, and that there were some problems with adherence.

In carrying out the invention, the copper surface is immersed into aqueous diluted sulfuric acid solution to clean the surface after polishing and degreasing as pretreatment. After rinsing, it is immersed into an aqueous solution containing diethylenetriamine penta-acetic acid and copper ions and electrolysis is conducted by using it as a cathode.

The bath contains diethylenetriamine penta-acetic acid as 10 - 300 g/L of sodium diethylenetriamine penta-acetate (hereinafter described as DTPA.5Na), more preferably 40 - 100 g/L copper ions as 10 - 100 g/L of cupric sulfate (5 H₂0 salt), more preferably 30 - 50 g/L , and its PH is adjusted to 2.5 - 13.0, more preferably 3.5 - 7.0, by adding sulfuric acid. The weight ratio of DTPA. 5Na/cupric sulfate(5H₂0 salt) is preferably 0.5-5.0. The bath temperature is 30-60°C, more preferably 40-50°C. The current density is 2 - 10 A/dm², the treatment time is 1 - 120 seconds, giving 10 - 500 A.sec/dm² the total quantity of electricity, more preferably 30-100 A.sec/dm². At below 10A.sec/dm² the particle size of the rough surface formed is extremely minute (below 0.02 - 0.03 µ m) and it is difficult to obtain satisfactory peel strength with the resin. At a quantity of electricity over 500 A.sec/dm², the bondability of the rough surface is obtained, but the particle size is larger (over 1.5 - 1.9 µ m), which is unfavourable when forming a fine pattern by using a liquid resist. As the anode in electrolysis, copper is preferably used.

Even if aminocarboxylic acids such as ethylenediamine tetra-acetic acid having a molecular structure similar to diethylenetriamine penta-acetic acid are used in place of diethylenetriamine penta-acetic acid, a rough surface good in bondability is not obtained.

After electrolytic treatment by the above-mentioned method the rough surface is rinsed, dried and the process for forming the rough surface is finished. In the case of long-term storage of the rough surface until the circuit pattern forming process, that is the next process, or in the case of copper foil for printed circuit boards, the surface may be immersed in an aqueous solution containing benzotriazol and derivatives thereof to provide corrosion resistance by forming an organic film on the surface. The surface may be subjected to a general chromate treatment such as immersion in an aqueous solution of bichromate.

Before peeling off the etching resist after forming the circuit pattern, the copper surface of circuit pattern on the thickness direction of the copper clad laminate may be subjected to soft etching by cupric chloride-hydrochloric acid to roughen the surface a little thereby the bondability of surface with resin is elevated. The conditions of soft etching in this case are, for example, 20 g/L of cupric chloride (2H₂0 salt), 300 cm³/L of concentrated hydrochloric acid and at 25°C of bath temperature the surface is subjected to immersion treatment for 30 - 60 seconds.

By the above-mentioned treatment, as shown in the attached photograph, a high density of particles of 0.1 - 0.2 µ m in size is formed on the copper surface. Therefore, the printed circuit board using copper foil subjected to the above treatment has excellent acid resistance, generating no haloing pink-ring phenomenon and no lowering of the peel strength of the resin with the copper foil. Further, printed circuit boards using copper foil subjected to the above treatment have excellent heat resistance in soldering without lowering of the adhesive strength of the solder. The above treatment, avoiding high temperature treatment is simple in working and involves few steps, leading to lower costs.

### BRIEF DESCRIPTION OF THE DRAWINGS

Fig. 1(a) - (h) is a typical section of the method for producing multilayer printed circuit plates according to the invention;

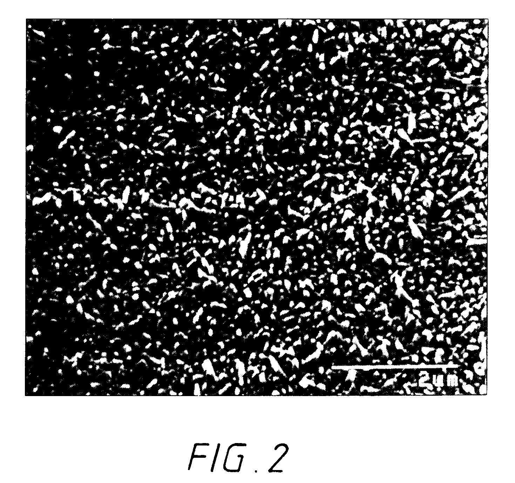

Fig. 2 is an electronic micrograph (15000 fold) of the fine copper rough surface obtained in Example 1 by the method according to the invention.

### EXAMPLE

### (Example 1)

Glass-fiber reinforced epoxy-resin of FR-4 grade and electrolytic copper foil of 35 µ m in thickness were laminated by pressing to obtain a double-sided board. After polishing the copper surface, it was immersed into aqueous 3% H₂SO₄ solution at room temperature for 20 seconds. Both sides were rinsed and subjected to cathodic electrolysis in a bath of the following composition:

| | |
|---|---|
| DTPA.5Na | 52 g/L |
| Cupric sulfate (5H₂0 salt) | 45 g/L |
| PH (adjusted by sulfuric acid) | 4.0 |
| Bath temperature | 48°C |

at 4 A/dm² of current density for 15 seconds. Both sides were then rinsed and dried. Then, bonding sheet prepregs were inserted between both sides and external substrate (single sided board) and secondary lamination was conducted to obtain a multilayer laminate (4 layers). The copper foil on the external layer was removed by etching to drill a hole of 0.8mm in diameter and the laminate was immersed in 20wt% hydrochloric acid for 1 hour and then whether a haloing pink-ring was generated by penetration of hydrochloric acid into the internal surface or not was judged.

Separately, electrolytic copper foil of 35 µ m in thickness was, after polishing the shiny side, immersed into aqueous 3% H₂SO₄ solution at room temperature for 20 seconds, rinsed, and subjected to cathodic electrolysis in the above-mentioned bath composition under the same conditions. After rinsing and drying, the thus obtained copper rough surface was observed under a scanning electronic microscope and it was confirmed that the rough surface was composed of uniform fine particle-form of 0.1 - 0.2 µ m in size. The copper foil was laminated with a substrate of FR-4 grade to examine the peel strength hydrochloric acid resistance and solder heat resistance. The results are shown in Table 2.

### (Example 2 - 10)

Glass-fiber reinforced epoxy-resin of FR-4 grade and electrolytic copper foil of 35 µ m in thickness were laminated by pressing to obtain a double-sided board. After polishing the copper surface it was immersed into aqueous 3% H₂SO₄ solution at room temperature for 20 seconds. The laminate was rinsed and subjected to cathodic electrolysis in a similar manner to Example 1 under the bath conditions shown in Table 1 (pH adjusted by sulfuric acid). After rinsing and drying a bonding sheet prepreg was inserted between both the sides and external substrate (single-sided board) and secondary lamination was conducted to obtain a multilayer laminate (4 layers). The copper foil on the external layer was removed by etching to drill a hole of 0.8 mm in diameter and the laminate was immersed in 20wt% hydrochloric acid for 1 hour, and then whether hydrochloric acid had penetrated into the internal surface or not was judged. The results are shown in Table 2. Separately, electrolytic copper foil of 35 µ m in thickness was, after polishing the shiny side, immersed into aqueous 3% H₂SO₄ solution at room temperature for 20 seconds, rinsed, and subjected to cathodic electrolysis under the bath composition and conditions shown in Table 1. After rinsing and drying, the copper foil was laminated with a substrate of FR-4 grade to examine the peel strength hydrochloric acid resistance and solder heat resistance. The results are shown in Table 2. From the results, the copper rough surface according to the invention is excellent in hydrochloric acid resistance, showing no occurrence of haloing pink-ring phenomenon and no lowering in peel strength after soldering, thereby the method of treating copper surface according to the invention is proved to be excellent.

### (Example for comparison 1)

Glass-fiber reinforced epoxy-resin of FR-4 grade and electrolytic copper foil of 35 µ m in thickness were laminated by pressing to obtain a double-sided board. After polishing the copper surface it was immersed in an aqueous 3% H₂SO₄ solution at room temperature for 20 seconds. The laminate was rinsed and immersed in a bath for black-oxide treatment of the following composition for 60 seconds.

| | |
|---|---|
| NaClO₂ | 60 g/L |
| Na₃PO_{4.} 12H₂O | 10 g/L |
| NaOH | 12 g/L |
| Bath temperature | 98°C |

After rinsing and drying, bonding sheet prepregs were inserted between both the sides and external substrate (single-sided boards) and it was laminated by heating to obtain a multilayer laminate (4 layers). The copper foil on the external layer was removed by etching to drill a hole of 0.8 mm in diameter and the laminate was immersed in 20wt% hydrochloric acid for 1 hour, and then whether hydrochloric acid had penetrated into the internal surface or not was judged. The results are shown in Table 2. As shown in the results, the usual black-oxide treatment shows very poor hydrochloric acid resistance, generating the haloing pink-ring phenomenon. Separately, electrolytic copper foil of 35 µ m in thickness was, after polishing the shiny side, immersed into aqueous 3% H₂SO₄ solution at room temperature for 20 seconds. After rinsing, the copper foil was immersed into the above-mentioned black-oxide treatment bath for 60 seconds. After rinsing and drying, the copper foil was laminated with a substrate of FR-4 grade to examine the peel strength hydrochloric acid resistance and solder heat resistance. The results are shown in Table 2. Remarkable lowering of peel strength is shown after soldering, whereby peeling off of layers due to heat shock in soldering may occur, making the method unreliable and unsuitable for high density circuits.

### (Example for comparison 2)

Glass-fiber reinforced epoxy-resin of FR-4 grade and electrolytic copper foil of 35 µ m in thickness were laminated by pressing to obtain a double-sided board. After polishing the copper surface it was immersed into aqueous 3% H₂SO₄ solution at room temperature for 20 seconds. The laminate was rinsed and immersed into a bath for black-oxide treatment of the following composition for 30 seconds.

| | |
|---|---|
| CuCl₂.H₂O | 30 g/L |
| HC1(36%) | 300 cm³/L |
| Bath temperature | 25°C |

The laminate was rinsed and immersed into a bath for black-oxide treatment of the following composition for 60 seconds.

| | |
|---|---|
| NaClO₂ | 80 g/L |
| Na₃PO_{4.}12H₂O | 10 g/L |
| NaOH | 8 g/L |
| Bath temperature | 94°C |

After rinsing and drying, bonding sheet prepregs were inserted between both the sides and external substrate (single-sided boards) and it was laminated by heating to obtain a multi layer laminate (4 layers). The copper foil on the external layer was removed by etching to drill a hole of 0.8 mm in diameter and the laminate was immersed in 20wt% hydrochloric acid for 1 hour, and then whether hydrochloric acid had penetrated into the internal surface or not was judged. The results are shown in Table 2.

Separately, electrolytic copper foil of 35 µ m in thickness was, after polishing the shiny side, immersed into aqueous 3% H₂SO₄ solution at room temperature for 20 seconds. After rinsing, it was treated in a similar manner as above in the above-mentioned cupric chloride-hydrochloric acid bath. After rinsing, it was immersed in the above-mentioned black-oxide treatment bath for 60 seconds.

After rinsing and drying, the copper foil was laminated with a substrate of FR-4 grade to examine the peel strength hydrochloric acid resistance and solder heat resistance. The results are shown in Table 2. The hydrochloric resistance is also very poor in this case, and a remarkable lowering of peel strength is also shown after immersion in solder, being proved to be unreliable.

**Table 1**

| Example NO. | Conditions for making rough surface | | | | | |
|---|---|---|---|---|---|---|
| | DTPA · 5Na (g/ℓ) | CuSO₄ · 5H₂O (g/ℓ) | PH | Temperature (°C) | Current density (A/dm²) | Electrolysis time(seconds) |
| 1 | 52 | 40 | 4.0 | 48 | 4.0 | 15 |
| 2 | 60 | 40 | 4.5 | 45 | 4.0 | 5 |
| 3 | 50 | 40 | 4.5 | 50 | 4.0 | 20 |
| 4 | 80 | 60 | 4.5 | 45 | 8.0 | 7 |
| 5 | 50 | 40 | 3.5 | 40 | 3.0 | 20 |
| 6 | 60 | 40 | 4.5 | 45 | 4.0 | 100 |
| 7 | 70 | 45 | 7.0 | 45 | 8.0 | 8 |
| 8 | 150 | 70 | 3.9 | 35 | 5.0 | 18 |
| 9 | 20 | 20 | 3.8 | 37 | 3.0 | 20 |
| 10 | 72 | 45 | 12.0 | 45 | 8.0 | 7 |

**Table 2**

| | | Internal layer treatment Haloing pink-ring test *1 | Peeling off strength (Kg/cm) *2 | | |
|---|---|---|---|---|---|
| | | | normal state | after immersion in hydrochoric acid (20wt% HCl 25°C, 20 min.) | after immersion in solder (250°C, 20 sec, float) |
| Example | 1 | ○ | 1.27 | 1.25 | 1.24 |
| | 2 | ○ | 1.12 | 1.10 | 1.10 |
| | 3 | ○ | 1.30 | 1.30 | 1.28 |
| | 4 | ○ | 1.08 | 1.05 | 1.03 |
| | 5 | ○ | 1.10 | 1.07 | 1.04 |
| | 6 | ○ | 1.20 | 1.17 | 1.17 |
| | 7 | ○ | 1.11 | 1.10 | 1.11 |
| | 8 | ○ | 1.21 | 1.20 | 1.18 |
| | 9 | ○ | 1.12 | 1.12 | 1.10 |
| | 10 | ○ | 1.14 | 1.12 | 1.12 |
| Example for comparison- | 1 | X | 1.25 | 0.00 | 0.75 |
| | 2 | X | 1.39 | 0.00 | 0.98 |

| | | | | | |
|---|---|---|---|---|---|
| *1 ○ ... No soaking of hydrochloric acid X ... Large soaking depth (over 2mm) | | | | | |
| *2 Test at 1 mm only in width according to JIS-C-6481 | | | | | |

## Claims

1. A method of forming a laminate including a copper foil layer, in which method the copper foil is subjected to surface roughening treatment to improve its adhesion, characterized in that the roughening treatment comprises the electro-deposition of copper from an aqueous solution containing diethylenetriamine penta-acetic acid or a salt thereof and copper ions, at a current density of from 2 to 10 A/dm² and a charge of from 10 to 500 A.sec/dm² so as to produce an adherent layer having a particle size between 0.03 and 1.5 micro-metres.

2. A method according to claim 1 in which the current density and charge are chosen to produce a layer having a particle size between 0.1 and 0.2 micro-metres.

3. A method according to claim 1 or claim 2, wherein the plating station comprises from 10 to 300 g/L of sodium diethylenetriamine penta-acetate, from 10 to 100 g/L of cupric sulfate at a pH of 2.5-13 at a temperature of 30°C - 60°.

4. A method according to any preceding claim wherein the said diethylenetriamine penta-acetate acid in the aqueous solution is present as the pentasodium salt in amount of 40 - 100g/L.

5. A method according to any preceding claim, wherein the said copper ions in the aqueous solution are present as cupric sulfate in amount of 30 - 50 g/L.

6. A method according to any preceding claim, wherein the temperature of the solution is 40 - 50°C.

7. A method according to any preceding claim, wherein the pH of the solution is 3.5 - 7.0.

## Patentansprüche

1. Verfahren zur Herstellung eines Laminats mit einer Kupferfolienschicht, bei dem die Kupferfolie zur Verbesserung ihrer Hafteigenschaften einer Behandlung zum Aufrauhen ihrer Oberfläche unterzogen wird, **dadurch gekennzeichnet,** daß man zur Aufrauhbehandlung aus einer Diethylentriaminpentaessigsäure oder ein Salz derselben sowie Kupferionen enthaltenden wässrigen Lösung mit einer Stromdichte von 2 A/dm² bis 10 A/dm² und einer Ladung von 10 A·s/dm² bis 500 A·s/dm² galvanisch Kupfer aufbringt, um eine haftende Schicht mit einer Teilchengröße zwischen 0,03 µm und 1,5 µm zu erzeugen,

2. Verfahren nach Anspruch 1, **dadurch gekennzeichnet,** daß die Stromdichte und Ladung so gewählt werden, daß eine Schicht mit einer Teilchengröße Von 0,1 µm bis 0,2 µm erzeugt wird.

3. Verfahren nach Anspruch 1 oder Anspruch 2, **dadurch gekennzeichnet,** daß die Metallisierungsstation 10 g/Liter bis 300 g/Liter Natrium-Diethylentriaminpentaacetat sowie 10 g/Liter bis 100 g/Liter Liter Kupfer(II)-Sulfat bei einem pH-Wert von 2,5 bis 13 sowie einer Temperatur von 30°C bis 60°C aufweist.

4. Verfahren nach einem aor vorgehenden Ansprüche, **dadurch gekennzeichnet**, daß die Diethylentriaminpentaessigsäure als Pentanatriumsalz in einer Menge von 40 g/Liter bis 10 g/ Liter in der wässrigen Lösung vorliegt.

5. Verfahren nach einem der vorgehenden Ansprüche, **dadurch gekennzeichnet**, daß die Kupferionen als Kupfer(II)-Sulfat in einer Menge von 30 g/Liter bis 50 g/Liter in der wässrigen Lösung vorliegen.

6. Verfahren nach einem der vorgehenden Ansprüche, **dadurch gekennzeichnet**, daß die Temperatur der Lösung 40°C bis 50°C beträgt.

7. Verfahren nach einem der vorgehenden Ansprüche, **dadurch gekennzeichnet**, daß der pH-Wert der Lösung 3,5 bis 7,0 ist.

## Revendications

1. Procédé de formation d'un stratifié comprenant une couche de feuille de cuivre, dans lequel la feuille de cuivre est soumise à un traitement rendant la surface rugueuse afin d'améliorer son adhérence, caractérisé en ce que le traitement de rugosité comprend le dépôt électrolytique de cuivre à partir d'une solution aqueuse contenant de l'acide diéthylènetriaminepentaacétique ou un sel de celui-ci et des ions cuivre, à une densité de courant comprise entre 2 et 10 A/dm² et une charge comprise entre 10 et 500 A.s/dm² de façon à produire une couche adhérente ayant une dimension de particules comprise entre 0,03 et 1,5 µm.

2. Procédé selon la revendication 1, dans lequel la densité de courant et la charge sont choisies de façon à produire une couche ayant une dimension de particules comprise entre 0,1 et 0,2 µm.

3. Procédé selon la revendication 1 ou la revendication 2, dans lequel le poste de dépôt électrolytique comprend de 10 à 300 g/l de diéthylènetriaminepentaacétate de sodium, de 10 à 100 g/l de sulfate cuivrique à un pH compris entre 2,5 et 13, à une température comprise entre 30 et 60°C.

4. Procédé selon l'une quelconque des revendications précédentes, dans lequel ledit acide diéthylènetriaminepentaacétique dans la solution aqueuse est présent sous forme du sel pentasodique à raison de 40 à 10 g/l.

5. Procédé selon l'une quelconque des revendications précédentes, dans lequel lesdits ions cuivre dans la solution aqueuse sont présents sous forme de sulfate cuivrique à raison de 30 à 50 g/l.

6. Procédé selon l'une quelconque des revendications précédentes, dans lequel la température de la solution est comprise entre 40 et 50°C.

7. Procédé selon l'une des revendications précédentes, dans lequel le pH de la solution est compris entre 3,5 et 7,0.
